# FASCICULE DE BREVET EUROPEEN

(11) **EP 1 949 779 B1**
(45) Date de publication et mention de la délivrance du brevet: **13.02.2013**
(21) Numéro de dépôt: 06819183.2
(22) Date de dépôt: 30.10.2006
(51) Int. Cl.: H05K 13/04

(54) **DISPOSITIF ET PROCEDE DE RETOURNEMENT DE COMPOSANTS ELECTRONIQUES**
VORRICHTUNG UND VERFAHREN ZUM KIPPEN VON ELEKTRONISCHEN BAUELEMENTEN
DEVICE AND METHOD OF INVERTING ELECTRONIC COMPONENTS

(30) Priorité: 15.11.2005 CH 18342005
(43) Date de publication de la demande: 30.07.2008
(73) Titulaire: ISMECA Semiconductor Holding SA, 2300 La Chaux-de-Fonds (CH)
(72) Inventeur: OBERLI, Marco, CH-2300 La Chaux-de-Fonds (CH); DROMARD, Pascal, F-25500 Montlebon (FR)
(74) Mandataire: P&TS SA (AG, Ltd.)
(86) Numéro de dépôt international: PCT/EP2006/067910
(87) Numéro de publication internationale: WO 2007/057291

(56) Documents cités:
- WO-A-2004/023858
- US-A- 4 135 630
- US-B1- 6 468 023

## Description

### Domaine technique

La présente invention concerne un dispositif de retournement de composants électroniques.

Au cours de leur fabrication ou de leur test, les composants électroniques parcourent successivement différents emplacements de traitement. Les emplacements sont souvent régulièrement espacés sur la périphérie d'un barillet dont la rotation indexée permet de déplacer les composants d'un emplacement à l'autre.

Chacun de ces emplacements est généralement occupé par un poste de traitement effectuant une ou plusieurs opérations sur les composants électroniques qui lui sont présentés. Dans certains cas, un poste de traitement peut occuper plusieurs emplacements. L'ensemble des postes de traitement disposés autour du barillet forme ainsi un cycle d'opérations successives, par exemple de tests électriques ou mécaniques, d'opérations de conditionnement, etc., auquel les composants électroniques convoyés sur le barillet sont soumis. On connaît par exemple des barillets à 16 ou à 32 emplacements.

Le premier poste de traitement du cycle est généralement un poste d'entrée dont le rôle consiste essentiellement à amener les composants électroniques, depuis un réservoir ou depuis un autre convoyeur, sur le barillet. Le cycle peut comprendre un ou plusieurs postes de sortie, permettant ainsi de sortir les composants à différentes étapes du cycle, par exemple en fonction de caractéristiques mesurées sur un précédent poste de test.

Il arrive souvent que deux postes de traitement successifs doivent accéder à des faces opposées des composants électroniques. Par exemple, un poste de marquage doit pouvoir accéder à la face supérieure du composant à marquer alors que le test électrique de circuit intégré est souvent effectué en position retournée, dite « dead bug ». Il est donc nécessaire de retourner les composants électroniques entre les deux postes de traitement.

La demande de brevet WO2004/023858 au nom de la demanderesse décrit un dispositif de retournement avantageux parce qu'il occupe un seul poste de traitement. Le retournement des composants est toutefois provoqué par un actionneur linéaire, par exemple un vérin pneumatique. Un tel vérin est généralement plus lent et plus difficile à contrôler qu'un moteur électrique rotatif. L'actionneur agit sur une tige dont les va-et-vient verticaux provoquent le passage et le retournement des composants d'un porte-composant à un autre. L'axe de cette tige se confond cependant avec l'axe de rotation des porte-composants. Le moteur entraînant les porte-composants en rotation doit donc être placé de manière désaxée ; dans cette solution, il est relié par une courroie au mécanisme de retournement. Il est cependant difficile de transmettre des mouvements extrêmement rapides avec une précision très élevée au moyen de courroies. Par ailleurs, le composant retourné revenant sur son emplacement initial, il est nécessaire d'effectuer les opérations de retournement en temps masqué du convoyeur, ce qui est uniquement possible si la vitesse du dispositif de retournement est nettement plus importante que la vitesse du convoyeur. Cette solution est donc idéale essentiellement lorsque l'exigence d'occuper un seul emplacement autour du barillet est impérative.

D'autres solutions existent qui font appel à un bras à l'extrémité duquel se trouve un élément de préhension destiné à saisir le composant électronique et à le maintenir pendant que le bras tourne de 180° pour retourner le composant. La réalisation de cet élément de préhension, en regard d'une face latérale du composant, est cependant délicate.

US-B1-6,468,023 décrit un mécanisme de retournement qui fait appel à un bras en rotation autour d'un axe horizontal. Le bras fait des allers-retours entre un emplacement de début de retournement et un emplacement de fin de retournement. Le moteur actionnant le bras doit donc changer de sens de rotation deux fois à chaque cycle, en sorte qu'il est difficile d'obtenir des vitesses très élevées. D'autre part, la masse en rotation avec le bras est très importante. En outre, la position du composant retourné n'est pas entièrement contrôlée.

Un but de la présente invention est donc de proposer un dispositif de retournement de composants électroniques amélioré par rapport aux dispositifs de l'art antérieur.

Un autre but est de proposer un dispositif de retournement apte à retourner des composants électroniques entre deux postes de traitement successifs d'un convoyeur ou d'un barillet rotatif.

Selon l'invention, ces buts sont atteints au moyen d'un dispositif de retournement de composants électroniques comportant :
un plateau rotatif pour entraîner les composants électroniques à retourner successivement entre les emplacements fixes suivants: un emplacement de chargement sur le plateau, un emplacement de début de retournement, un emplacement de fin de retournement, et un emplacement de déchargement du plateau,
un dispositif de retournement actionné par un moteur rotatif fixe, non lié audit plateau, pour retourner lesdits composants électroniques entre ladite position de début de retournement et la position de fin de retournement.

Cette solution a l'avantage d'employer uniquement des moteurs rotatifs, qu'il est en outre possible de faire tourner dans un seul sens tout au long d'un cycle de retournement. Dans une variante, le moteur entraînant le plateau rotatif tourne toujours dans le même sens tandis que le moteur rotatif fixe actionnant le dispositif de retournement effectue des al lers-retours.

Cette solution a aussi l'avantage de séparer le moteur de retournement du plateau rotatif, et d'éviter un encombrement autour de l'axe de rotation du plateau.

L'invention sera mieux comprise à la lecture de la description annexée illustrée par les figures qui montrent :
La figure 1 une vue partielle du dispositif de retournement depuis dessus.
La figure 2 une vue latérale partielle du dispositif de retournement.

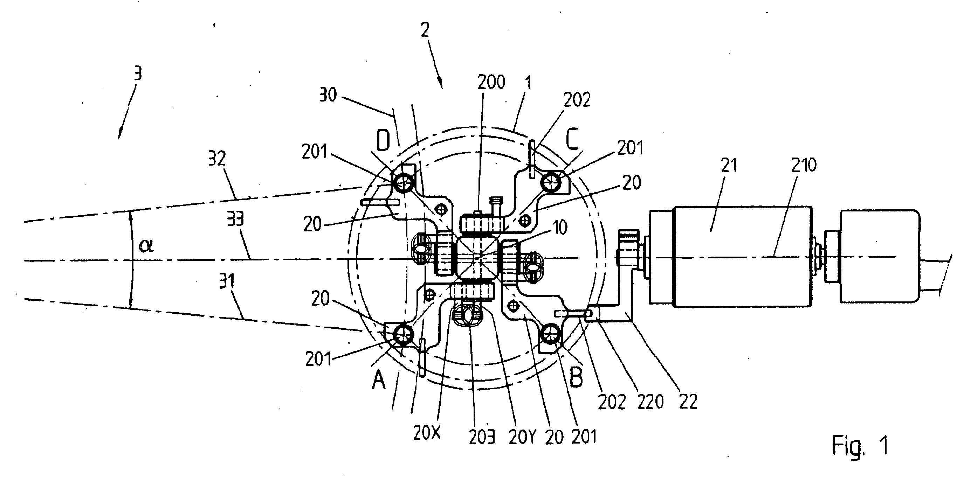

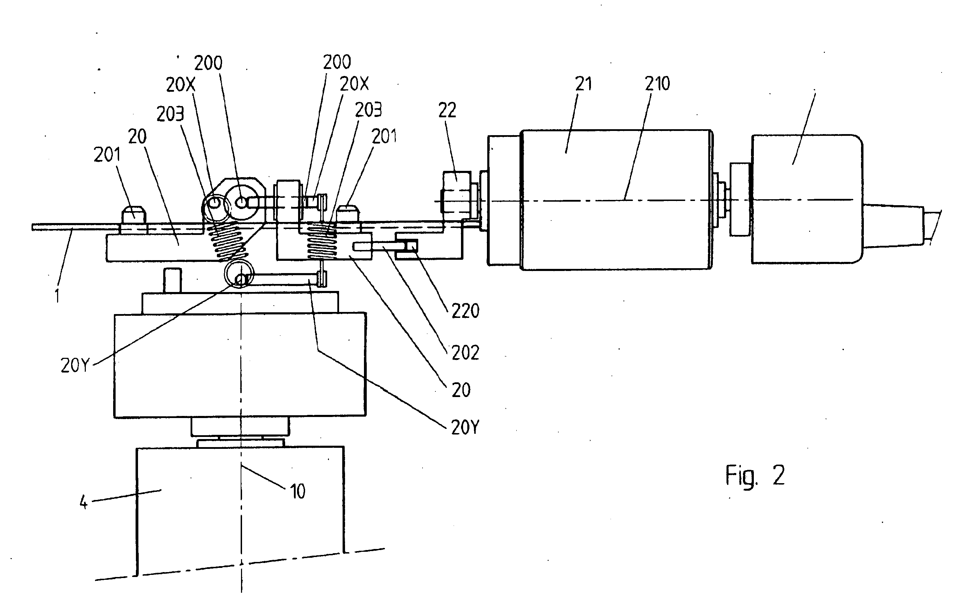

Le dispositif de retournement de l'invention est représenté sur les figures 1 et 2 ; seuls les composants nécessaires à la compréhension du procédé de retournement ont été illustrés. Le dispositif de retournement est destiné à coopérer avec un convoyeur qui apporte une succession de composants dans une première position, par exemple avec les pattes en bas, et les reprend en position retournée, par exemple avec les pattes en haut. Dans cet exemple préférentiel, le convoyeur est constitué par un barillet rotatif 3 à axe vertical dont seule une portion angulaire de la périphérie 30 est représentée de manière schématique. Le barillet comporte par exemple 16 ou 32 emplacements périphériques sur lesquels sont disposés des postes de traitement. Les mouvements de rotation du barillet sont de préférence indexés ; les composants à traiter passent d'un emplacement à l'autre à chaque pas et parcourent ainsi successivement ces différents postes de traitement pour être testés, marqués, conditionnés, etc.

Le dispositif de retournement de l'invention occupe deux emplacements successifs du barillet 3. Les composants électroniques à retourner sont extraits du barillet en un premier emplacement et placés sur un premier emplacement A du plateau rotatif 1 du dispositif de retournement. Dans ce mode de réalisation, le plateau rotatif 1 est horizontal ; il est entraîné en rotation de manière indexée par le moteur électrique 4 (par exemple un moteur à courant continu ou un moteur pas-à-pas), de manière à parcourir les quatre emplacements successifs A-B-C-D. Le composant est retourné entre les emplacements B et C et déchargé du plateau rotatif 1 à l'emplacement D, où il rejoint un deuxième emplacement du barillet 3. La référence 31 sur la figure 1 indique le rayon du premier emplacement du barillet, d'où sont extraits les composés électroniques chargés sur le plateau rotatif. La référence 32 correspond au rayon du deuxième emplacement où sont positionnés les composants retournés depuis le dernier emplacement D du plateau rotatif.

Le composant à retourner est placé sur le porte-composant 20 à l'emplacement A à partir du barillet 3 grâce à des moyens de placement non représentés. Les moyens de placement ainsi que la forme du porte-composant collaborent afin que la position du composant sur le porte-composant soit déterminée avec précision, et de manière reproductible d'un composant à l'autre. Le porte-composant 20 est muni d'une buse 201, reliée à un canal pneumatique non représenté, qui permet d'aspirer ou de souffler de l'air afin de maintenir le composant en place ou au contraire de le repousser. Dans une variante, le circuit pneumatique permet aussi de générer un « point neutre » stable dans lequel le composant n'est ni repoussé, ni aspiré ; une commande permet de le faire passer directement à ce point neutre. Le canal pneumatique comporte de préférence un chemin circulaire, non représenté, permettant à la buse de rester connectée au canal lors de ses rotations.

Le porte composant 20 est articulé autour de l'axe de retournement parallèle au plateau horizontal 200. Un ressort 203, visible sur la figure 2, maintient le porte-composant 20 dans la position sensiblement horizontale illustrée sur les figures 1 et 2. Le ressort 203 est tendu entre l'axe 20X, solidaire de la pièce 20, et l'axe 20Y solidaire du châssis. Le porte-composant 20 peut de préférence pivoter de 180° au moins autour de l'axe 200, de manière à retourner le composant par rapport à un plan horizontal tout en le déplaçant. L'axe 200 est positionné au-dessus du plan du porte-composant sur lequel est placé le composant à retourner, au milieu de l'épaisseur du composant, de manière à permettre le retournement d'un porte composant à l'emplacement B par-dessus un autre porte-composant à l'emplacement C, les buses des deux porte-composants étant alors alignées autour d'un même axe vertical.

Une dimension du composant à l'emplacement B est alignée par rapport au rayon 31 qui mène au centre du barillet 3 en passant par le premier emplacement du barillet. L'axe de rotation 200 du porte-composant à l'emplacement B est en revanche parallèle à l'axe de symétrie 33 entre deux emplacements successifs du barillet. En retournant le composant autour de l'axe 200, on aligne ainsi sa dimension par rapport au rayon 32 passant par le deuxième emplacement. Le déplacement du composant entre la position B et la position C est donc une combinaison entre un retournement autour d'un axe horizontal et une rotation d'angle α autour de l'axe vertical passant par le centre du barillet 3.

Le retournement du porte-composant à l'emplacement B est actionné par le moteur de retournement 21, par exemple un moteur rotatif à courant continu ou un moteur pas-à-pas. L'axe 210 de rotation du moteur 21 est horizontal et dans le même plan que l'axe de retournement 200. Dans la variante préférentielle illustrée, l'axe 210 et l'axe 200 sont même confondus. Le moteur entraîne une pièce excentrique 22 dont l'extrémité est munie d'une fente 220 qui permet de recevoir une tige 202 horizontale liée au porte-composant à l'emplacement B. Une liaison cinématique entre le moteur 21 et le porte-composant 20 existe donc uniquement lorsque que ce dernier se trouve à l'emplacement B. La pièce excentrique 22 est ainsi agencée pour engrener uniquement avec la tige 202 associée au porte-composant à l'emplacement B.

La rotation du moteur entraîne la tige 202 dans une direction comportant une composante verticale, soulevant ainsi le porte-composant à l'encontre de la force du ressort 203 et le retournant autour de l'axe 200, jusqu'à ce qu'il soit superposé au porte-composant à l'emplacement C. Le composant peut alors être déposé sur le porte-composant à l'emplacement C en contrôlant la pression pneumatique sur les buses 201 de façon appropriée, comme décrit plus bas.

Nous allons maintenant décrire le cycle parcouru par un par un composant entre les emplacements A et D du plateau rotatif. Le composant à retourner quitte le barillet 3 et est placé sur l'emplacement A du porte-composant. Le circuit pneumatique est commandé de manière à maintenir le composant en place par aspiration d'air au travers de la buse 201 de cet emplacement. D'autres moyens de maintien du composant peuvent être utilisés dans le cadre de l'invention, y compris des moyens de préhension mécaniques.

Le moteur 4 fait ensuite pivoter le plateau rotatif 1 avec les quatre porte-composants de 90° dans le sens anti-horaire, en sorte que le composant se retrouve maintenant à l'emplacement de début de retournement B. L'amplitude précise de la rotation est de préférence contrôlée au moyen d'un codeur angulaire fournissant un signal de rétroaction à une électronique de commande du moteur 4. Lors de cette rotation, la tige 202 associée au porte-composant vient se loger dans la fente 220 de la pièce excentrique 22.

Le retournement est ensuite effectué au moyen du moteur 21 qui actionne la pièce excentrique 22 de manière à soulever le porte-composant 20 à l'emplacement B et à le faire pivoter de 180° autour de l'axe 200. A nouveau, l'amplitude de la rotation du moteur 21 est contrôlée au moyen d'un deuxième codeur angulaire agissant sur le courant de commande du moteur 21, ou grâce à des détecteurs de fin de course. Le vide d'air sous la buse 201 est maintenu lors du retournement, de manière à maintenir le composant en place. Simultanément, la buse 201 du porte-composant à l'emplacement C est actionnée par le système pneumatique de manière à créer un léger vide d'air, ou une pression neutre.

A la fin du retournement, lorsque le composant se trouve au-dessus de la buse à l'emplacement C, le système pneumatique est contrôlé de manière à interrompre l'aspiration d'air par la buse liée au porte-composant retourné B, et à créer ou à augmenter le vide d'air de la buse liée au porte-composant C. Il est même possible de créer une légère surpression dans le circuit pneumatique lié au porte-composant B, de manière à repousser le composant. Le composant est ainsi décollé du porte-composant B, et attiré par le porte-composant C, sa position étant contrôlée avec précision.

Le porte-composant B retourne ensuite à son emplacement initial B. Dans une première variante, il est renvoyé à son emplacement initial au moyen du moteur 21 qui effectue un aller-retour pour replacer le porte-composant dans sa position B. Cette variante a cependant l'inconvénient de nécessiter un moteur 21 bidirectionnel, et de nécessiter des inversions de son sens de rotation, ce qui ralentit le procédé. Dans une autre variante, le ressort 203 est employé pour ramener le porte-composant dans sa position initiale. Dans ce but, le plateau rotatif 1 reprend sa rotation dans le sens anti-horaire, jusqu'à ce que la tige 201 se dégage de la fente 220 de la pièce excentrique. Le ressort 203 exerce alors une force de rappel pour ramener le porte-composant dans sa position initiale B.

Le cycle se poursuit avec la rotation du plateau rotatif de 90° dans le cycle anti-horaire. Le composant passe ainsi de l'emplacement C à l'emplacement D, où il peut être déchargé du plateau rotatif 1 et transféré en position retournée sur le convoyeur.

Le plateau rotatif 1 comporte 4 emplacements pour des composants 1. Il est bien entendu possible de commencer un nouveau cycle de retournement du composant suivant avant que le premier composant ait quitté le plateau. Dans une variante préférentielle, un nouveau composant est chargé sur l'emplacement A à chaque rotation du plateau, et un composant retourné est simultanément déchargé de l'emplacement D. Le composant passant directement de l'emplacement B à l'emplacement D entre deux rotations du plateau, il est ainsi possible d'occuper simultanément trois emplacements du plateau 1, et de charger respectivement décharger un composant à chaque rotation du barillet 3. Ainsi, aucune position du barillet ne reste vide : à chaque pas, un composant est déchargé sur l'emplacement A, et un autre composant retourné est chargé depuis l'emplacement D.

Le dispositif de retournement de l'invention comporte quatre emplacements successifs A, B, C et D. Il est cependant possible dans le cadre de l'invention de prévoir des dispositifs de retournement avec un nombre d'emplacements différents. Par exemple, le composant à retourner pourrait être chargé directement sur la position de début de retournement, ou directement déchargé de la position de fin de retournement, afin de réduire le nombre d'emplacements. Inversement, il est aussi possible de prévoir des emplacements intermédiaires pour du stockage intermittent ou pour effectuer des opérations supplémentaires, par exemple des opérations de retournement supplémentaires selon le même axe 200 ou selon un autre axe orthogonal par exemple. Par ailleurs, des opérations de marquage, de test, de tri, par exemple, pourraient aussi être effectuées sur ces emplacements intermédiaires.

Afin que les opérations décrites ci-dessus puissent être effectuées correctement et afin d'assurer le synchronisme des différents mouvements, l'ensemble des déplacements du barillet, des moteurs 4 et 21, ainsi que les pressions d'air dans les différentes chambres du circuit pneumatique sont de préférence contrôlés par un système de contrôle non représenté, par exemple un système numérique programmable de type CNC. Le système de contrôle peut être programmé par un programme qui peut être commercialisé ou mis à jour au travers de supports de données informatiques appropriés.

Dans la description de la variante préférentielle donnée ci-dessus à titre d'exemple, le dispositif de retournement est associé à un barillet circulaire. Il est cependant possible dans le cadre de l'invention d'associer le dispositif de retournement à un autre type de convoyeur, par exemple un convoyeur linéaire.

### Liste des éléments

- 1: Plateau rotatif
- 10: Axe de rotation du plateau rotatif
- A: Emplacement de chargement
- B: Emplacement de début de retournement
- C: Emplacement de fin de retournement
- D: Emplacement de déchargement
- 2: Dispositif de retournemement
- 20: Portes-composants
- 200: Axe de retournement du porte-composant
- 201: Buse
- 202: Tige
- 203: Ressort de rappel porte-composant
- 20X: Axe fixation du ressort sur pièce 20
- 20Y: Axe fixation du ressort sur pièce liée au châssis
- 21: Moteur fixe
- 210: Axe du moteur fixe
- 22: Pièce excentrique
- 220: Fente
- 3: Barillet
- 30: Circonférence liée au barillet
- 31: Axe position 1 sur le barillet
- 32: Axe position 2 sur le barillet
- 33: Axe de symmétrie entre emplacement 1 et emplacement 2
- α: Angle entre deux positions successives du barillet
- 4: Moteur du plateau rotatif

## Revendications

1. Dispositif comportant :
un plateau rotatif (1) pour entraîner des composants électroniques à retourner successivement entre les emplacements fixes suivants: un emplacement (A) de chargement sur le plateau, un emplacement (B) de début de retournement, un emplacement (C) de fin de retournement, et un emplacement (D) de déchargement du plateau,
un dispositif de retournement (2) des composants électroniques pour retourner lesdits composants électroniques entre ladite position de début de retournement et la position de fin de retournement,
**caractérisé en ce que** ledit dispositif de retournement est actionné par un moteur rotatif fixe (21), non lié audit plateau.

2. Le dispositif de la revendication 1, dans lequel lesdits emplacements fixes sont distincts les uns des autres.

3. Le dispositif de l'une des revendications 1 à 2, dans lequel ledit dispositif de retournement est agencé pour retourner lesdits composants électroniques de 180° autour d'un axe de retournement parallèle audit plateau rotatif (200).

4. Le dispositif de l'une des revendications 1 à 3, comportant un dispositif pneumatique coopérant avec ledit plateau rotatif (1) pour maintenir ou repousser lesdits composants électroniques.

5. Le dispositif de l'une des revendications 1 à 4, comportant des moyens de commande agencés pour faire tourner ledit plateau rotatif (1) toujours dans le même sens de manière indexée autour d'un axe vertical.

6. Le dispositif de l'une des revendications 1 à 5, ledit moteur rotatif fixe (21) ayant un axe (210) parallèle audit plateau.

7. Le dispositif de l'une des revendications 1 à 6, ledit dispositif de retournement comportant au moins un porte-composant (20) lié audit plateau (1) et articulé autour d'un axe de retournement (200) parallèle audit plateau et actionnable par ledit moteur fixe (21), de manière à pouvoir être retourné entre ledit emplacement de début de retournement (B) et ledit emplacement de fin de retournement (C) pour y déposer ledit composant électronique en position retournée.

8. Le dispositif de la revendication 7, dans lequel ledit axe du moteur fixe (210) et ledit axe de retournement (200) sont dans le même plan vertical.

9. Le dispositif de la revendication 8, dans lequel ledit axe du moteur fixe (210) et ledit axe de retournement (200) se confondent.

10. Le dispositif de l'une des revendications 7 à 9, comportant une pièce excentrique (22) entraînée par ledit moteur fixe (21) en rotation autour dudit axe de retournement (200) et agencée pour engrener successivement avec les dits porte-composants (20) successifs à l'emplacement de début de retournement (B).

11. Le dispositif de la revendication 10, dans lequel ladite pièce excentrique (22) et ledit porte-composant (20) sont agencés pour pouvoir coulisser l'un par rapport à l'autre selon une direction horizontale, et pour être solidaires l'un de l'autre selon une direction verticale.

12. Le dispositif de l'une des revendications 1 à 11, dans lequel ledit composant électronique est pivoté autour d'un axe vertical d'un angle (α) non nul entre le début de retournement (B) et la fin de retournement (C).

13. Procédé de retournement de composants électroniques comportant les étapes suivantes :
chargement du composant électronique à retourner sur un premier emplacement (A) d'un plateau rotatif (1),
rotation dudit plateau rotatif (1) de manière à placer ledit composant électronique en un emplacement (B) de début de retournement,
retournement dudit composant électronique au moyen d'un dispositif de retournement (2), de manière à placer ledit composant électronique en position retournée sur un emplacement de fin de retournement (C) distinct dudit emplacement de début de retournement,
déchargement dudit composant électronique depuis un emplacement de déchargement (D) du plateau rotatif (1),
**caractérisé en ce que** le dispositif de retournement est actionné par un moteur rotatif fixe (21).

14. Le procédé de la revendication 13, dans lequel ledit plateau rotatif (1) est pivoté de **90°** après le retournement dudit composant électronique et avant son déchargement.

15. Le procédé de l'une des revendications 13 ou 14, dans lequel plusieurs composants électroniques sont placés simultanément sur plusieurs emplacements dudit plateau rotatif (1).

16. Le procédé de l'une des revendications 13 à 15, dans lequel ledit plateau rotatif est actionné par un moteur rotatif (4),
et dans lequel le moteur du plateau rotatif et le moteur de retournement effectuent tous deux des rotations par pas dans un seul sens.

17. Le procédé de l'une des revendications 11 à 16, dans lequel le déplacement dudit composant électronique lors du retournement est la combinaison entre un retournement autour d'un axe horizontal et une rotation d'angle α autour d'un axe vertical.

18. Le procédé de l'une des revendications 11 à 17, dans lequel ledit moteur rotatif fixe (4) engrène avec le porte-composant (20) audit emplacement de début de retournement (B), et est dégréné dudit porte-composant lorsque celui-ci est pivoté.

19. Système comprenant:
un barillet rotatif (3) pour entraîner un composant électronique entre plusieurs emplacements de traitement consécutifs sur une périphérie (30) du barillet rotatif (3),
un dispositif de retournement selon l'une des revendications 1 à 12, monté entre deux dits emplacements consécutifs du barillet afin de retourner les composants électroniques entre ces deux emplacements.

## Claims

1. Device having:
a turntable (1) for driving the electronic components to be turned over in succession between the following stationary locations: a location (A) for loading them onto the turntable, a start of turning over location (B), an end of turning over location (C), and a location (D) for unloading the turntable,
a turning-over device (2), for turning over said electronic components between said start of turning over location and the end of turning over location, **characterized in that** said turning-over device is actuated by a fixed rotary motor (21) not linked to said turntable

2. The device of claim 1, wherein said fixed locations are distinct from one another.

3. The device of one of the claims 1 to 2, wherein said turning-over device is arranged for turning over said electronic components by 180° around a turning-over axis parallel to said turntable (200).

4. The device of one of the claims 1 to 3, having a pneumatic device working with said turntable (1) for holding or repelling said electronic components.

5. The device of one of the claims 1 to 4, having control means arranged for making said turntable (1) turn always in the same direction in indexed manner around a vertical axis.

6. The device of one of the claims 1 to 5, said fixed rotary motor (21) having an axis (210) parallel to said turntable.

7. The device of one of the claims 1 to 6, said turning-over device having at least one component-carrier (20) linked to said turntable (1) and articulated around a turning-over axis (200) parallel to said turntable and that can be actuated by said fixed motor (21) so that it can be turned over between said start of turning over location (B) and said end of turning over location (C) in order to place there said electronic component in turned-over position.

8. The device of claims 7, wherein said axis of the fixed motor (210) and said turning-over axis (200) are in the same vertical plane.

9. The device of claim 8, wherein said axis of the fixed motor (210) and said turning-over axis (200) merge.

10. The device of one of the claims 7 to 9, having an eccentric part (22) driven by said fixed motor (21) in rotation around said turning-over axis (200) and arranged for meshing in succession with said successive component-carriers (20) at the start of turning over location (B).

11. The device of claim 10, wherein said eccentric part (22) and said component-carrier (20) are arranged so as to be able to slide one relative to the other along a horizontal direction and to be solidly united one to another along a vertical direction.

12. The device of one of the claims 1 to 11, wherein said electronic component is made to pivot around a vertical axis by a non-zero angle (α) between the start of turning over location (B) and the end of turning over location (C).

13. Method for turning over electronic components having the following steps:
loading the electronic component to be turned over onto a first location (A) of a turntable (1),
rotating said turntable (1) so as to place said electronic component at a start of turning over location (B),
turning over said electronic component by means of a turning-over device (2), so as to place said electronic component in turned-over position onto an end of turning over location (C) distinct from said start of turning over location,
unloading said electronic component from an unloading location (D) of the turntable (1) **characterized in that** said turning-over device is actuated by a fixed rotary motor (21)

14. The method of claim 13, wherein said turntable (1) is made to pivot by 90° after turning over of said electronic component and before its unloading.

15. The method of one of the claims 13 or 14, wherein several electronic components are placed simultaneously onto several locations of said turntable (1).

16. The method of one of the claims 13 to 15, wherein said turntable is actuated by a rotary motor (4),
and wherein the motor of the turntable and the turning-over motor both perform step-wise rotations in a single direction.

17. The method of one of the claims 11 to 16, wherein the displacement of said electronic component during turning over is the combination of a turning over around a horizontal axis and an angular rotation **α** around a vertical axis.

18. The method of one of the claims 11 to 17, wherein said fixed rotary motor (4) meshes with the component-carrier (20) of said start of turning over location (B) and is unmeshed from said component-carrier once the latter has pivoted.

19. System comprising:
a rotating barrel (3) for driving an electronic component between several consecutive processing locations on a periphery (30) of the rotating barrel (3),
a turning-over device according to one of the claims 1 to 12, mounted between said two consecutive locations of the barrel in order to turn over the electronic components between these two locations.

## Patentansprüche

1. Vorrichtung aufweisend:
eine Drehscheibe (1) um umzudrehende elektronische Komponenten nacheinander zu den folgenden festen Orten zu fahren: Ein Ort (A) für das Laden der Komponenten auf die Drehscheibe (1), ein Ort (B) für den Beginn des Umdrehens, ein Ort (C) für das Ende des Umdrehens, und ein Ort (D) für das Entladen von der Drehscheibe (1);
eine Umdrehvorrichtung (2) zum Umdrehen der elektronischen Komponenten zwischen dem Ort für den Beginn des Umdrehens und dem Ort für das Ende des Umdrehens,
**dadurch gekennzeichnet, dass**
die Umdrehvorrichtung durch einen festen Drehmotor (21) angetrieben wird, der nicht mit der Drehscheibe verbunden ist.

2. Die Vorrichtung nach Anspruch 1, in der die festen Orte sich jeweils voneinander unterscheiden.

3. Die Vorrichtung nach Anspruch 1 oder 2, in der die Umdrehvorrichtung ausgebildet ist, die elektronischen Komponenten um 180° um eine Umdrehachse parallel zu der Drehscheibe (200) umzudrehen.

4. Die Vorrichtung nach einem der Ansprüche 1 bis 3, aufweisend eine pneumatische Vorrichtung kooperierend mit der Drehscheibe (1) für das Halten und Wegdrücken der elektronischen Komponenten.

5. Die Vorrichtung nach einem der Ansprüche 1 bis 4, aufweisend Steuermittel ausgebildet die Drehscheibe (1) in diskreten Schritten immer in die gleiche Richtung um eine Vertikale Achse zu drehen.

6. Die Vorrichtung nach einem der Ansprüche 1 bis 5, wobei der feste Drehmotor (21) eine Achse (210) parallel zu der Drehscheibe aufweist.

7. Die Vorrichtung nach einem der Ansprüche 1 bis 6, wobei die Umdrehvorrichtung mindestens einen Komponententräger (20) aufweist, der mit der Drehscheibe (1) verbunden ist und um eine zu der Drehscheibe parallele Umdrehachse (200) drehbar ist und durch den festen Motor (21) so angetrieben werden kann, dass der Komponententräger (20) zwischen dem Ort für den Beginn des Umdrehens (B) und dem Ort für das Ende des Umdrehens (C) umgedreht werden kann, um dort die elektronische Komponente in die umgedrehte Position zu bringen.

8. Die Vorrichtung nach Anspruch 7, wobei die Achse des festen Motors (210) und die Umdrehachse (200) in der gleichen vertikalen Ebene liegen.

9. Die Vorrichtung nach Anspruch 8, wobei die Achse des festen Motors (210) und die Umdrehachse (200) zusammenfallen.

10. Die Vorrichtung nach einem der Ansprüche 7 bis 9, aufweisend ein exzentrisches Teil (22), das durch den festen Motor (21) um die Umdrehachse (200) drehend angetrieben ist und das zum sukzessiven ineinandergreifen von nachfolgenden Komponententrägers (20) an dem Ort für den Beginn der Umdrehens (B) ausgebildet ist.

11. Die Vorrichtung nach Anspruch 10, wobei das exzentrische Teil (22) und der Komponententräger (20) so ausgebildet sind, dass sie relative zueinander entlang einer horizontalen Richtung gleiten können und dass sie entlang einer vertikalen Richtung fest zueinander fest verbunden sind.

12. Die Vorrichtung nach einem der Ansprüche 1 bis 11, wobei die elektronische Komponente um eine vertikale Achse um einen von Null verschiedenen Winkel zwischen dem Ort für den Beginn des Umdrehens und dem Ort für das Ende des Umdrehens drehbar ist.

13. Ein Verfahren zum Umdrehen elektronischer Komponenten aufweisend:
Laden der umzudrehenden elektronischen Komponente an einen ersten Ort (A) einer Drehscheibe (1);
Drehen der Drehscheibe (1), so dass die elektronische Komponente sich an einem Ort für den Beginn des Umdrehens (B) befindet;
Umdrehen der elektronischen Komponente mittels einer Umdrehvorrichtung (2), so dass sich die elektronische Komponente in der umgedrehten Stellung an einem Ort für das Ende des Umdrehens befindet, der vom Ort für den Beginn des Umdrehens verschieden ist,
Entladen der elektronischen Komponente von einem Entladeort,
**dadurch gekennzeichnet, dass**
die Umdrehvorrichtung durch einen festen Drehmotor (21) angetrieben wird.

14. Das Verfahren nach Anspruch 13, wobei die Drehscheibe (1) ausgebildet ist, nach dem Umdrehen und vor dem Entladen um 90° zu drehen.

15. Das Verfahren nach Anspruch 13 oder 14, wobei mehrere elektronische Komponenten gleichzeitig an mehreren Orten der Drehscheibe (1) positioniert werden.

16. Das Verfahren nach einem der Ansprüche 13 bis 15, wobei die Drehscheibe durch einen Drehmotor (4) angetrieben wird,
und wobei der Motor der Drehscheibe und der Umdrehvorrichtung beide eine schrittweise Drehung in eine einzelne Richtung durchführen.

17. Das Verfahren nach einem der Ansprüche 11 bis 16, wobei die Verschiebung der elektronischen Komponenten während des Umdrehens eine Kombination aus dem Umdrehen um eine horizontale Achse und einer Winkeldrehung α um eine vertikale Achse ist.

18. Das Verfahren nach einem der Ansprüche 11 bis 17, wobei der feste Drehmotor (4) in den Komponententräger (20) des Orts für den Beginn des Umdrehens eingreift und nicht in den Komponententräger eingreift, wenn letztere gedreht ist.

19. System aufweisend:
eine Drehtrommel (3) zum Antreiben einer elektronischen Komponente (3) zwischen verschiedenen nacheinander folgenden Verarbeitungsorten an dem Aussenbereich der Drehtrommel (3),
eine Umdrehvorrichtung nach Ansprüchen 1 bis 12, die zwischen zwei nacheinander folgenden Orten der Trommel montiert ist, um die elektronische Komponente zwischen diesen beiden Orten umzudrehen.
